# EUROPEAN PATENT APPLICATION

(11) **EP 3 525 345 A2**
(43) Date of publication of application: **14.08.2019**
(21) Application number: 19155737.0
(22) Date of filing: 06.02.2019
(51) Int. Cl.: H03G 3/30, H03G 7/00, H03G 9/02

(54) **AMPLIFICATION DEVICE**

(30) Priority: 13.02.2018 JP 2018022971
(71) Applicant: Onkyo Corporation, Osaka 572-0028 (JP)
(72) Inventor: OKA, Takuya, Osaka, Osaka 572-0028 (JP); TOMITA, Kazuki, Osaka, Osaka 572-0028 (JP); KITAZAKI, Tomoki, Osaka, Osaka 572-0028 (JP)
(74) Representative: Horn Kleimann Waitzhofer Patentanwälte PartG mbB

(57) **Abstract**

Problem: To provide a device which can suppress temperature rising at low cost. Solution: An AV amplifier 1 includes a volume circuit 4, a tone control circuit 5, a power amplifier 6 which amplifies an audio signal which is output from the volume circuit 4, and a microcomputer 2. When level of the audio signal is not less than a predetermined threshold, the microcomputer 2 increases gain of the audio signal to not less than maximum input voltage of the tone control circuit 5 by the volume circuit 4 and outputs the audio signal in which gain is increased to the tone control circuit 5. Further, the microcomputer 2 decreases gain of the audio signal which is output from the volume circuit 4 by the tone control circuit 5 and outputs the audio signal in which gain is decreased to the volume circuit 4.

## Description

The present invention relates to an amplification device which amplifies an audio signal.

### BACKGROUND ART

An AV amplifier (amplification device) includes an amplification circuit which amplifies an audio signal. Power supply voltage which is transformed by a transformer is supplied to the amplification circuit. For example, in the transformer, taps of two or three kinds in which winding number are different are provided (for example, see JP 2011-166456 A.). By changing the tap to be used, the power supply voltage which is supplied to the amplification circuit is changed to high voltage / middle voltage / low voltage, and it corresponds to a load which is connected to the amplification circuit. Concretely, in a device which can change two kinds of high voltage / low voltage, when the load of an amplifier is 8 ohm or 6 ohm, in an initial state, high voltage is supplied. When output level rises, low voltage is supplied in a threshold and it is hard that temperature rises. When the load is 4 ohm, in the initial state, low voltage is supplied, instead of output power which is not large, temperature does not rise. Herein, for cost cut of the AV amplifier, when the above high voltage / low voltage change function is not mounted, temperature consideration becomes severe. In the AV amplifier which mounts a DSP (Digital Signal Processor), by soft clip by the DSP, safety test condition can be eased.

### PATENT LITERATURE

PATENT LITERATURE 1: JP 2011-166456 A

### SUMMARY OF THE INVENTION

### PROBLEM TO BE RESOLVED BY THE INVENTION

As described above, for cost cut, when the voltage change function and the DSP are not mounted and a large heat sink cannot be used, there is a problem which cannot suppress temperature rising of the device.

An objective of the present invention is to provide a device which can suppress temperature rising at low cost.

### MEANS FOR SOLVING THE PROBLEM

An amplification device of a first invention comprising: a volume circuit; a circuit; an amplification circuit which amplifies an audio signal which is output from the volume circuit; and a controller, wherein the controller increases gain of the audio signal to not less than maximum input voltage of the circuit by the volume circuit and outputs the audio signal in which gain is increased to the circuit when level of the audio signal is not less than a predetermined threshold, and the controller decreases gain of the audio signal which is output from the circuit by the volume circuit.

In the present invention, when level of an audio signal is not less than a predetermined threshold, a controller increases gain of the audio signal to not less than maximum input voltage of a circuit by a volume circuit and outputs the audio signal in which gain is increased to the circuit. Further, the controller decreases gain of the audio signal which is output from the circuit by the volume circuit. Thus, the clipped audio signal in the circuit returns to the volume circuit and the clipped audio signal is output to an amplification circuit. In this manner, temperature rising can be suppressed even if voltage change function, a DSP, and a large heat sink are not mounted because the audio signal is clipped in the circuit. Namely, temperature rising can be suppressed at low cost.

The amplification device of a second invention is the amplification device of the first invention, wherein the controller adjusts volume of the audio signal by the volume circuit and outputs the audio signal in which volume is adjusted to the amplification circuit when level of the audio signal is less than the predetermined threshold.

The amplification device of a third invention is the amplification device of the first or the second invention, wherein the controller detects level of the audio signal which is output from the amplification circuit and judges whether level of the audio signal is not less than the predetermined threshold or not.

The amplification device of a fourth invention is the amplification device of any one of the first to the third inventions, wherein gain which is increased by the volume circuit and gain which is decreased by the volume circuit are equal.

The amplification device of a fifth invention is the amplification device of any one of the first to the fourth inventions, wherein the volume circuit is a first volume circuit, the circuit is a second volume circuit, the controller increases gain of the audio signal to not less than maximum input voltage of the second volume circuit by the first volume circuit and outputs the audio signal in which gain is increased to the second volume circuit when level of the audio signal is not less than a predetermined threshold, and the controller decreases gain of the audio signal which is output from the first circuit by the second volume circuit instead of the first volume circuit and outputs the audio signal in which gain is decreased to the first volume circuit.

The amplification device of a sixth invention is the amplification device of any one of the first to the fifth inventions, wherein the circuit is a tone control circuit which adjusts tone of the audio signal.

In the present invention, the circuit is a tone control circuit which adjusts tone of the audio signal. For this reason, cost can be cut because it is not necessary to mount a new circuit as the circuit for clipping the audio signal.

### EFFECT OF THE INVENTION

According to the present invention, temperature rising can be suppressed at low cost.

### BRIEF DESCRIPTION OF THE DRAWINGS

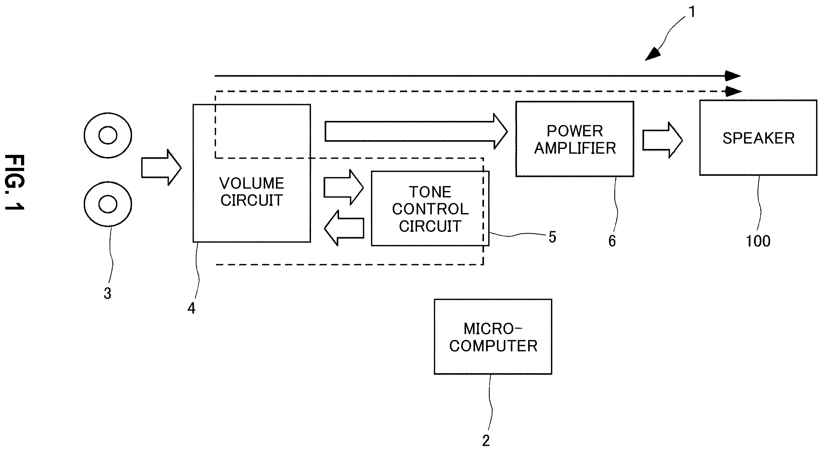

Fig. 1 is a block diagram illustrating a constitution of an AV amplifier according to an embodiment of the present invention.

### DESCRIPTION OF THE EMBODIMENTS

An embodiment of the present invention is described below. Fig. 1 is a block diagram illustrating a constitution of an AV amplifier according to the present embodiment. The AV amplifier 1 (amplification device) amplifies an audio signal which is input from an external device such as a CD player or the like and outputs the amplified audio signal to a speaker 100. As illustrated in Fig. 1, the AV amplifier 1 includes a microcomputer 2, an input terminal 3, a volume circuit 4, a tone control circuit 5, a power amplifier 6 and so on.

The microcomputer 2 (controller) is composed of hardware such as a CPU (Central Processing Unit), a ROM (Read Only Memory), a RAM (Random Access Memory), an input and output interface and so on. The CPU controls respective section composing the AV amplifier 1 according to a program which is stored in the ROM. Namely, the microcomputer 2 controls respective section composing the AV amplifier 1. The RAM temporarily stores a program that the CPU reads from the ROM when the CPU performs various control process, necessary data when the CPU performs various control process and so on. The RAM is a volatile memory in which stored data disappears when supply of power is cut off.

The audio signal is input to the input terminal 3 from the external device. The audio signal which is input to the input terminal 3 is output to the volume circuit 4. The volume circuit 4 (first volume circuit) normally adjusts volume of the input audio signal and outputs the audio signal in which volume is adjusted to the power amplifier 6. The power amplifier 6 (amplification circuit) amplifies the audio signal which is output from the volume circuit 4 and outputs the amplified audio signal to the speaker 100. The speaker 100 outputs an audio based on the input audio signal. The tone control circuit 5 (second volume circuit) is a circuit which adjusts tone of the audio signal and has volume adjustment function of the audio signal.

The microcomputer 2 detects level of the audio signal which is output from the power amplifier 6. Concretely, the audio signal from the power amplifier 6 is also supplied to an A/D port of the microcomputer 2. The microcomputer 2 A/D-converts the audio signal which is supplied to the A/D port and detects signal level. The power amplifier 6 includes multiple amplifiers (for example, transistors) and the audio signal from the multiple amplifiers is added, and the added audio signal is supplied to the A/D port of the microcomputer 2.

The microcomputer 2 judges whether level of the audio signal which is supplied to the A/D port is not less than a predetermined threshold or not. For example, the predetermined threshold is the audio signal level in temperature test. When the microcomputer 2 judges that level of the audio signal is less than the predetermined threshold (normal operation), the microcomputer 2 adjusts volume of the audio signal by the volume circuit 4 and outputs the volume-adjusted audio signal to the power amplifier 6. The audio signal is output to the speaker 100 by route of solid line as illustrated in Fig. 1.

When the microcomputer 2 judges that level of the audio signal is not less than the predetermined threshold (for example, in temperature test), the microcomputer 2 increases gain of the audio signal to not less than maximum input voltage of the tone control circuit 5 by the volume circuit 4 and outputs the audio signal in which gain is increased to the tone control circuit 5. Further, the microcomputer 2 decreases gain of the audio signal which is output from the volume circuit 4 and outputs the audio signal in which gain is decreased to the volume circuit 4. Thus, the clipped audio signal in the tone control circuit 5 returns to the volume circuit 4 and the clipped audio signal is output to the power amplifier 6. The audio signal is output to the speaker 100 by route of dashed line as illustrated in Fig. 2. In this manner, temperature rising can be suppressed even if voltage change function, a DSP, and a large heat sink are not mounted because the audio signal is clipped in the tone control circuit 4. Namely, temperature rising can be suppressed at low cost.

In the route which is illustrated by the solid line, it is necessary to adjust total gain of the volume circuit 4 and the tone control circuit 5 in order to maintain gain value of the volume circuit 4. Further, in the tone control circuit 5, gain which is increased by the volume circuit 4 is decreased, and total gain is adjusted. Namely, gain which is increased by the volume circuit 4 and gain which is decreased by the tone control circuit are equal.

Further, the AV amplifier 1 is normal operation (the route which is illustrated by the solid line) when the load is 8 ohm. In the AV amplifier 1, when the load is 4 ohm and not less than regulation output power is output, the above described soft clip is applied (the route which is illustrated by the dashed line) and test voltage in 1/8 can be decreased.

As described above, as a circuit which decreases gain, by using the tone control circuit 5, cost can be cut because it is not necessary to mount a new circuit as the circuit which decreases gain.

The embodiment of the present invention is described above, but the mode to which the present invention is applicable is not limited to the above embodiment and can be suitably varied without departing from the scope of the present invention.

In the above described embodiment, as the circuit which decreases gain, the tone control circuit 5 is illustrated. Not limited to this, the circuit may be other than the tone control circuit 5 as long as the circuit has volume adjustment function.

In the above described embodiment, when level of the audio signal is not less than the predetermined threshold, the microcomputer 2 increases gain of the audio signal to not less than maximum input voltage of the tone control circuit 5 by the volume circuit 4, outputs the audio signal in which gain is increased to the tone control circuit 5, decreases gain of the audio signal which is output from the volume circuit 4 by the tone control circuit 5, and outputs the audio signal in which gain is decreased to the volume circuit 4.

Not limited to this, when level of the audio signal is not less than the predetermined threshold, the microcomputer 2 may increase gain of the audio signal to not less than maximum input voltage of the tone control circuit 5 by the volume circuit 4, output the audio signal in which gain is increased to the tone control circuit 5, and decrease gain of the audio signal which is output from the tone control circuit 5 by the volume circuit 4. Namely, increase and decrease of gain may be performed by only the volume circuit 4. In this case, a circuit to clip may be not a tone control circuit which has volume adjustment function and be a buffer or the like, for example.

### INDUSTRIAL APPICABILITY

The present invention can be suitably employed in an amplification device which amplifies an audio signal.

### REFERENCE SIGNS

- 1: AV amplifier (amplification device)
- 2: microcomputer (controller)
- 3: input terminal
- 4: volume circuit (first volume circuit)
- 5: tone control circuit (second volume circuit)
- 6: power amplifier (amplification circuit)
- 100: speaker

## Claims

1. An amplification device comprising:
a volume circuit;
a circuit;
an amplification circuit which amplifies an audio signal which is output from the volume circuit; and
a controller, wherein
the controller increases gain of the audio signal to not less than maximum input voltage of the circuit by the volume circuit and outputs the audio signal in which gain is increased to the circuit when level of the audio signal is not less than a predetermined threshold, and
the controller decreases gain of the audio signal which is output from the circuit by the volume circuit.

2. The amplification device according to claim 1,
wherein the controller adjusts volume of the audio signal by the volume circuit and outputs the audio signal in which volume is adjusted to the amplification circuit when level of the audio signal is less than the predetermined threshold.

3. The amplification device according to claim 1 or 2,
wherein the controller detects level of the audio signal which is output from the amplification circuit and judges whether level of the audio signal is not less than the predetermined threshold or not.

4. The amplification device according to any one of claims 1 to 3,
wherein gain which is increased by the volume circuit and gain which is decreased by the volume circuit are equal.

5. The amplification device according to any one of claims 1 to 4,
wherein the volume circuit is a first volume circuit,
the circuit is a second volume circuit,
the controller increases gain of the audio signal to not less than maximum input voltage of the second volume circuit by the first volume circuit and outputs the audio signal in which gain is increased to the second volume circuit when level of the audio signal is not less than a predetermined threshold, and
the controller decreases gain of the audio signal which is output from the first circuit by the second volume circuit instead of the first volume circuit and outputs the audio signal in which gain is decreased to the first volume circuit.

6. The amplification device according to any one of claims 1 to 5, wherein the circuit is a tone control circuit which adjust tone of the audio signal.
